(19) Europäisches Patentamt / European Patent Office / Office européen des brevets

(11) **EP 3 953 720 B1**

(12) **EUROPÄISCHE PATENTSCHRIFT**

(45) Veröffentlichungstag und Bekanntmachung des Hinweises auf die Patenterteilung:
**29.05.2024 Patentblatt 2024/22**

(21) Anmeldenummer: **20736265.8**

(22) Anmeldetag: **23.06.2020**

(51) Internationale Patentklassifikation (IPC):
**G01R 31/64** (2020.01)   **G01R 27/26** (2006.01)
**G01R 31/40** (2020.01)

(52) Gemeinsame Patentklassifikation (CPC):
**G01R 31/64; G01R 27/2605;** G01R 31/40;
Y02B 70/10

(86) Internationale Anmeldenummer:
**PCT/EP2020/067506**

(87) Internationale Veröffentlichungsnummer:
**WO 2020/260284 (30.12.2020 Gazette 2020/53)**

(54) **SCHALTUNG UND VERFAHREN ZUR ÜBERWACHUNG EINES ZWISCHENKREISKONDENSATORS**

CIRCUIT AND METHOD FOR MONITORING A DC LINK CAPACITOR

CIRCUIT ET PROCÉDÉ DE SURVEILLANCE D'UN CONDENSATEUR DE CIRCUIT INTERMÉDIAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.06.2019 DE 102019117369**

(43) Veröffentlichungstag der Anmeldung:
**16.02.2022 Patentblatt 2022/07**

(73) Patentinhaber: **ebm-papst Mulfingen GmbH & Co. KG**
**74673 Mulfingen (DE)**

(72) Erfinder:
• **SCHROTH, Sebastian**
**74635 Kupferzell (DE)**
• **KERSCHREITER, Andreas**
**84174 Eching (DE)**
• **WEINGART, Markus**
**84056 Rottenburg (DE)**

(74) Vertreter: **Staeger & Sperling Partnerschaftsgesellschaft mbB**
**Sonnenstraße 19**
**80331 München (DE)**

(56) Entgegenhaltungen:
**DE-A1-102013 112 538     US-A1- 2009 072 982**

• **GUSTAVO MALAGONI BUIATTI ET AL: "An Online and Noninvasive Technique for the Condition Monitoring of Capacitors in Boost Converters", IEEE TRANSACTIONS ON INSTRUMENTATION AND MEASUREMENT, IEEE SERVICE CENTER, PISCATAWAY, NJ, US, Bd. 59, Nr. 8, 1. August 2010 (2010-08-01), Seiten 2134-2143, XP011296546, ISSN: 0018-9456**

**Beschreibung**

Die vorliegende Erfindung betrifft zunächst eine elektrische Schaltung und ein Verfahren zur Überwachung eines Zwischenkreiskondensators in einer solchen elektrischen Schaltung, insbesondere in einer elektronischen Ansteuerschaltung für einen elektronisch kommutierten Elektromotor, kurz EC-Motor.

In elektronischen Schaltungen von bestimmten elektrischen Vorrichtungen werden häufig Aluminium-Elektrolytkondensatoren, kurz Alu-Elkos, als Energiespeicher bzw. Zwischenkreiskondensatoren eingesetzt. Ein großer Nachteil liegt darin, dass ein Alu-Elko während des Betriebes, insbesondere auf Grund einer Verdunstung bzw. Verdampfung seines flüssigen Elektrolyts, einer Alterung unterliegt und daher den hauptsächlichen, die Lebensdauer der Vorrichtung begrenzenden Faktor darstellt.

Die Geschwindigkeit der Alterung und damit die zur Verfügung stehende Betriebszeit bis zum Ende der Lebens- bzw. Brauchbarkeitsdauer sind von verschiedenen Parametern abhängig, darunter beispielsweise auch der jeweiligen Umgebungstemperatur und der Strombelastung des Elkos während des Betriebes.

Mittels geeigneter empirischer Berechnungsmethoden kann theoretisch abgeschätzt werden, wann das Ende der Lebensdauer eines Zwischenkreiskondensators erreicht wird. Da es sich aber um ein rein theoretisch abgeschätztes Gebrauchsdauerende handelt, hat dies nicht zwangsläufig einen unmittelbaren Defekt des Elkos zur Folge bzw. kann die Abschätzung auch recht ungenau sein.

Eine hinreichende Funktion des Zwischenkreiskondensators in der jeweiligen Vorrichtung und damit auch der Vorrichtung selbst kann grundsätzlich auch dann noch eine bestimmte Zeit gegeben sein. Deshalb ist eine theoretische Lebensdauer-Berechnung für die Praxis zu ungenau.

Die Druckschrift DE 10 2016 004 774 A1 zeigt ein Ausführungsbeispiel bei dem eine Messung mit Hilfe eines eingeprägten Gleichstroms erfolgt unter Verwendung eines Ramp-Up zur Ermittlung der Zwischenkreiskapazität. Allerdings erfolgt dort die Messung zum Zeitpunkt zwischen dem Einschalten und aufgeladenem Zwischenkreis. Wünschenswert wäre aber eine Messung während dem tatsächlichen Betrieb der Schaltung.

Die Druckschrift DE 10 2004 036 211 A1 beschreibt ein weiteres Verfahren zur Ermittlung der Alterung eines Elektrolytkondensators. Dabei sollen die tatsächlichen Einsatzbedingungen berücksichtigt werden. Der Elektrolytkondensator wird mittels eines zuschaltbaren Vorladewiderstandes geladen, wobei während eines Vorladevorgangs auf eine bestimmte Weise durch Spannungsmessungen eine Zeitkonstante des Vorladevorgangs berechnet wird, die anschließend mit einer vorbestimmten Zeitkonstante verglichen wird. Eine ermittelte Abweichung wird als Maß für die Alterung des Elektrolytkondensators gewertet.

Aus dem Dokument EP 2 637 030 A1 ist eine Lösung bekannt, mittels einer Messung über hochfrequente HF-Ripple basierend auf der Schaltfrequenz der Kommutierungsschaltung, wozu jedoch eine Zusatzbeschaltung notwendig ist.

In dem aus dem Stand der Technik bekannten Dokument DE 10 2004 035 723 A1 sind ein Verfahren und eine Vorrichtung zur Ermittlung einer Restlebensdauer eines Elektrolytkondensators eines Frequenzumrichters beschrieben. Hiernach wird eine Restlebensdauer eines Elektrolytkondensators mit Hilfe seiner berechneten Kerntemperatur und einer korrespondierenden Lebensdauer berechnet. Die Kerntemperatur wird mit Hilfe der gemessenen Umgebungstemperatur und seiner berechneten Verlustleistung bestimmt. Aus der Lebensdauer wird jeweils eine Alterungsgeschwindigkeit berechnet, die zu einem tatsächlichen Lebensalter aufintegriert wird, und die subtrahiert von einem Lebensdauerende die jeweilige Restlebensdauer ergibt. Die Verlustleistung wird in Abhängigkeit von einer gemessenen Zwischenkreisspannung, einem gemessenen Motorstrom, einer ermittelten Motorspannung, der Kapazität des Elkos und in ihm wirksamer Innenwiderstände berechnet. Alles in allem führt dies zu einem großen Rechenaufwand.

Schließlich betrifft das Dokument DE 10 2004 052 977 A1 ein weiteres Diagnoseverfahren zum Bestimmen des Alterungszustandes eines Kondensators. Dabei werden jeweils mehrere alterungsabhängige Parameter des Kondensators durch verschiedene Entladungsvorgänge gemessen.

Dokument US2009/072982 offenbart ein Verfahren zur Überwachung der Brummspannung an einem Kondensator, durch Umwandlung der Brummspannung in ein Pulsweitenmodulationssignal (PWM) oder ein Effektivwertsignal (RMS). Eine Leistungsverschlechterung des Kondensators wird auf der Grundlage der überwachten Spannung erkannt.

Das Dokument "An Online and Noninvasive Technique for the Condition Monitoring of Capacitors in Boost Converters" von GUSTAVO MALAGONI BUIATTI ET AL,IEEE TRANSACTIONS ON INSTRUMENTATION AND MEASUREMENT, IEEE SERVICE CENTER, PISCATAWAY, NJ, US, Bd. 59, Nr. 8, 1. August 2010 (2010-08-01), Seiten 2134-2143, XP011296546,ISSN: 0018-9456 offenbart eine Technik basiert auf der doppelten Schätzung des ESR und der Kapazität, was die Zuverlässigkeit der Diagnose verbessert.

Der vorliegenden Erfindung liegt die Aufgabe zu Grunde, eine einfach und kostengünstig realisierbare Lebensdauer-Überwachung eines Zwischenkreiskondensators im laufenden Betrieb zu ermöglichen, welche kostengünstig zu realisieren ist.

Diese Aufgabe wird durch ein Verfahren nach Anspruch 1, sowie eine elektrische Schaltung nach Anspruch 7 gelöst.

Ein Grundgedanke der Erfindung betrifft die Detektion des Zustands des Zwischenkreiskondensators, bzw. dessen Kapazität durch Messung des mit der doppelten Netzfrequenz pulsierende Ripples der Zwischenkreisspannung aufgrund einer ebenfalls pulsierenden Leistungsaufnahme der Gesamtschaltung aus PFC und Inverter. Durch eine Leistungsmessung und Ripple-Spannungsmessung am Zwischenkreiskondensator erfolgt bevorzugt durch ein mathematisches Modell die Bestimmung der Zwischenkreiskapazität. Neuartig dabei ist unter anderem, dass die Messung mit der im EC-Motor vorhandener Sensorik erfolgt und somit keine zusätzliche Schaltungstechnik oder Sensorik benötigt wird, was kostengünstige Realisierung ermöglicht.

Über die Veränderung der Rippelspannung am Zwischenkreiskondensator kann auf dessen Kapazität und somit auf die Rippelspannung geschlossen werden.

Erfindungsgemäß wird hierzu Verfahren zur Überwachung eines Zwischenkreiskondensators in einem elektrischen Zwischenkreis einer an einer Netzspannung $V_{ac}$ betriebenen Schaltung vorgesehen, umfassend einen Leistungsfaktorkorrekturfilter und einen Inverter, wobei sich zwischen dem Leistungsfaktorkorrekturfilter und dem Inverter der zu überwachende Zwischenkreiskondensator befindet, wobei während dem Betrieb der Schaltung wenigstens in bestimmten Zeitabständen über die Betriebszeit die Zwischenkreiskapazität C des Zwischenkreiskondensators durch Messen eines mit der doppelten Frequenz der Netzspannung pulsierenden Leistungsrippels W einer am Zwischenkreiskondensators sich einstellenden Zwischenkreisspannung ermittelt und mittels einer Auswerteschaltung aus der so ermittelten Zwischenkreiskapazität C eine Rest-Lebensdauer oder das Lebensdauer- und/oder Brauchbarkeitsdauer-Ende des Zwischenkreiskondensators bestimmt wird.

Besonders vorteilhaft ist es, wenn zur Ermittlung der Zwischenkreiskapazität C des Zwischenkreiskondensators eine Leistungsmessung und eine Spannungsmessung am Zwischenkreiskondensators zur Bestimmung des Spannungsrippels erfolgt.

Weiter vorteilhaft ist es, wenn die das Verfahren zur Überwachung des Zwischenkreiskondensators eines über eine den Zwischenkreiskondensator aufweisende Motorsteuerungsschaltung betriebenen EC-Motor verwendet wird, wobei die Motorsteuerungsschaltung eine Sensorik zum Betrieb des EC-Motors aufweist und diese Sensorik gleichzeitig zur Leistungserfassung und/oder Spannungsmessung des Spannungsrippels am Zwischenkreiskondensators verwendet wird. Auf diese Weise wird sichergestellt, dass keine zusätzliche Schaltungstechnik oder Sensorik benötigt wird.

Erfindungsgemäß ist der Leistungsfaktorkorrekturfilter (PFC) ein aktiver Leistungsfaktorkorrekturfilter ist und die Erfassung der über eine Netzhalbwelle aufgenommene Leistung des Leistungsfaktorkorrekturfilters mittels der zur Regelung des Leistungsfaktorkorrekturfilters bereits zuvor ermittelten Netzeingangsspannung und dem bereits dazu ermittelten Eingangsstrom $i_{Netz}$ erfolgt.

In einer alternativen Ausgestaltung der Erfindung ist vorgesehen, dass die Leistungserfassung ohne Kenntnis der Netzeingangsspannung $V_{ac}$ erfolgt, indem zunächst der Strom $i_D$ durch eine Boost-Diode des Leistungsfaktorkorrekturfilters ermittelt wird und wobei aus folgendem Zusammenhang und der Erfassung des Inverterstroms $I_{inv}$ der verbleibende Anteil ermittelt wird, der als Zwischenkreiskondensatorstrom $I_{ZK}$ zum Zwischenkreiskondensator fließt: $I_{ZK} = i_D - I_{inv}$ und daraus sich unmittelbar durch Integration des Stromes $I_{ZK}$ oder durch Bestimmung der Ladungsträger der aktuelle Kapazitätswert des Zwischenkreiskondensators bestimmen lässt.

Weiter vorteilhaft ist es dabei, wenn die Stromerfassung des Stromes $i_D$ mittels indirekter Messung aus dem gemessenen Netzstrom erfolgt, indem mit Hilfe eines Duty-Cycles berechnet wird, welcher Anteil des Stroms durch die Boost-Diode fließt. Alternativ kann auch eine direkte Strommessung erfolgen.

In einer ebenfalls vorteilhaften jedoch alternativen Ausgestaltung der Erfindung ist vorgesehen, dass die Ermittlung der Zwischenkreiskapazität durch ein Beobachtersystem erfolgt, wobei der Strom $i_D$ durch eine Diode und der Inverterstrom $I_{inv}$ durch Messen der beiden Ströme erfolgt und die Differenz als Zwischenkreiskondensatorstrom $I_{ZK}$ betrachtet wird und dieser mit einem Kapazitätswert $C_{est}$ multipliziert und anschließend integriert wird und die hierdurch am Integrierer des Beobachtersystems entstehende Ausgangsspannung $U_{ZK\_est}$ wird mittels eines Hochpasses gefiltert, um dadurch den hochpassgefilterten Spannungsrippel $U_{ZK\_est,HP}$ zu erhalten, um diesen von einer hochpassgefilterten Netzspannung $U_{ZK,Netz,HP}$ zu subtrahieren und die ermittelte Differenz $\Delta U$ wird aufintegriert und als $C_{est}$ angegeben, wodurch eine Beobachter/Regelschleife erhalten wird, die das Modell schleifenweise dem tatsächlich gemessenen Kondensator nachführt.

Ein weiterer Aspekt der vorliegenden Erfindung betrifft auch die Schaltung zur Überwachung eines Zwischenkreiskondensators in einem elektrischen Zwischenkreis umfassend einen Leistungsfaktorkorrekturfilter und einen Inverter, wobei sich zwischen dem Leistungsfaktorkorrekturfilter und dem Inverter der zu überwachende Zwischenkreiskondensator befindet und ferner eine Auswerteschaltung vorgesehen ist, die ausgebildet ist, das zuvor beschriebene Verfahren durchzuführen und dabei insbesondere physikalische Messwerte von dem Leistungsfaktorkorrekturfilter und dem Inverter zu erhalten oder zu erfassen und bei der Ermittlung der Rest-Lebensdauer oder des Lebensdauer- und/oder Brauchbarkeitsdauer-Endes des Zwischenkreiskondensators zu verwenden.

Ein ebenfalls weiterer Aspekt der Erfindung betrifft dem Umstand, dass durch Alterung, externe Temperatureinflüsse sowie Eigenerwärmung durch Ripple-Ströme die Zwischenkreiskondensatoren mit der Zeit an ihrer Kapazität verlieren. Meist wird ein Ende der Kondensator-Lebensdauer mit dem Erreichen einer Untergenze von -25% unter dem Initialwert der Kapazität festgelegt.

Ein weiteres Ziel dieser Erfindung ist es, über den Zusammenhang des Laststroms zu Spannungsripple auf die verbleibende Kondensatorkapazität zu schließen. Hierzu erfolgt eine Bestimmung der Netzfrequenz, eine Messung des Spannungsripples über eine Netzperiode sowie eine Messung des Laststroms in Form der Verwendung des bereits bekannten Motorstroms.

Eine entsprechend intelligente Filterung verhindert, dass bei Fehlmessungen oder externen Störeinflüssen versehentlich eine Meldung ausgegeben wird. Weiterhin erfolgt die Bewertung in Relation zum Initialwert des Kondensators, weshalb zum Erstinbetriebnahmezeitpunkt eine initialisierende Messung erfolgen muss.

Die Erfindung zielt auf die Messung der Kapazität des Zwischenkreiskondensators (Elektrolyt-Typ) und die Abschätzung der daraus resultierenden verbleibenden Lebensdauer im laufenden Betrieb der Elektronik ab. Das Konzept sieht die Berechnung der Kapazität über die Messung der Kenngrößen wie die der Brummspannung $\Delta U\_d$, Laststrom $I\_L$ und der Frequenz der Netzspannung $f\_{ac}$ vor. Der Zusammenhang lässt sich mathematisch wie folgt darstellen:

$$C_{Elko} = \frac{\bar{I}_L}{\Delta U_d * 2 * f_{ac}}$$

Eine zeitliche Mittelung der berechneten Kapazitätswerte C_x in Kombination mit dem Initialwert der Kapazität C_0 gibt Aufschluss über die verbleibende Lebensdauer des Elektrolyt-Kondensators.

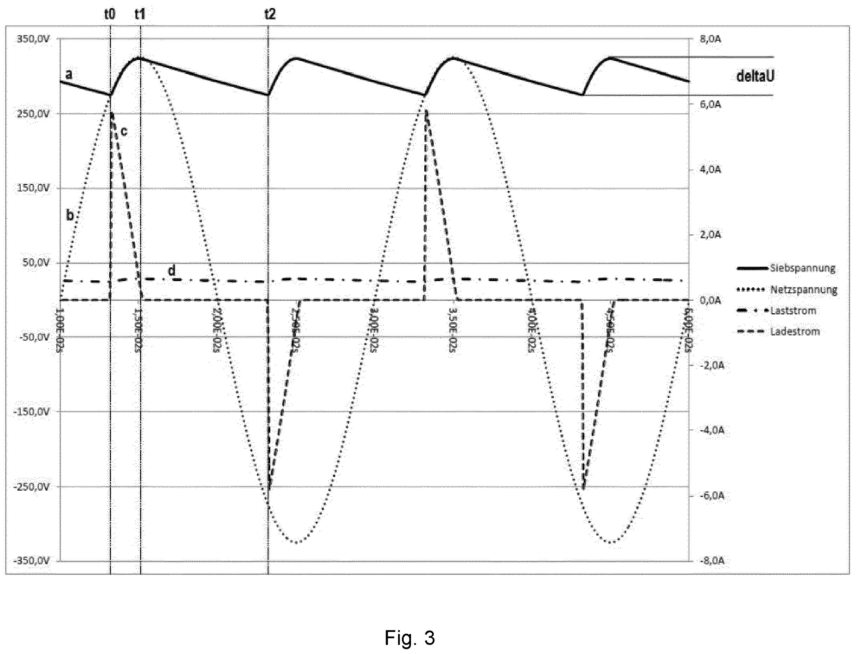

Durch die weiter oben beschriebene Bestimmung der Zwischenkreiskapazität ergeben sich optional besondere Ausgestaltungen der Erfindung, die mit Bezug auf die Fig. 3 näher erläutert werden.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt.

Es zeigt:

Fig. 1 eine schematische Konzeptzeichnung der Realisierung eines ersten Ausführungsbeispiels einer erfindungsgemäßen Schaltungstopologie,

Fig. 2 eine schematische Konzeptzeichnung der Realisierung eines alternativen Ausführungsbeispiels und

Fig. 3 ein Diagramm mit Erläuterung von Kenngrößenverläufen aufgetragen gegenüber der Spannung.

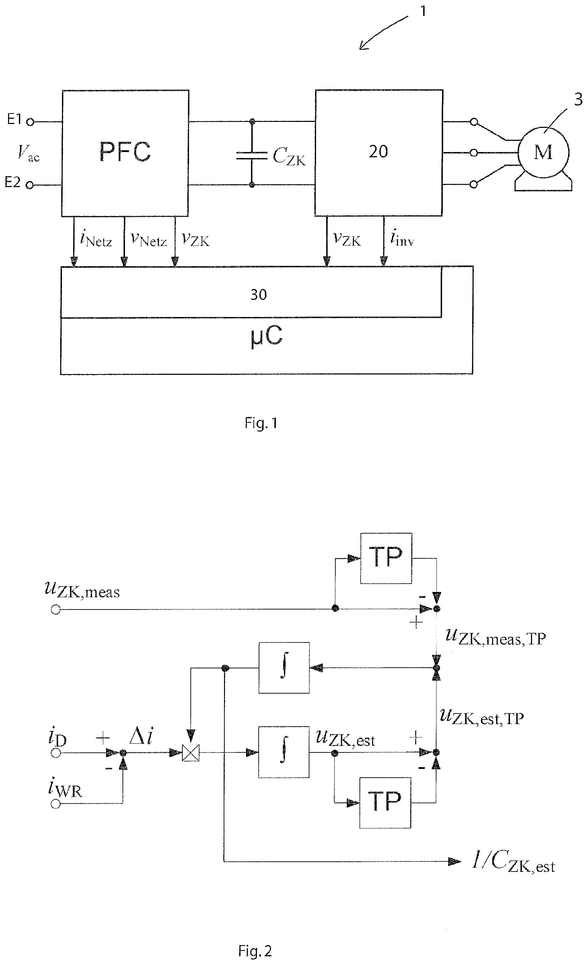

Im Folgenden wird die Erfindung anhand der beiden gezeigten Ausführungsbeispiele mit Bezug auf die Figuren 1 bis 3 näher beschrieben, wobei gleiche Bezugszeichen in den Figuren auf gleiche strukturelle und/oder funktionale Merkmale hinweisen.

In der Fig. 1 ist ein Prinzipschaltbild der grundsätzlichen Schaltungstopologie eines ersten Ausführungsbeispiels der vorliegenden Erfindung gezeigt, mit der sich die Kapazität und daraus die Lebensdauer eines Zwischenkreiskondensators $C_{ZK}$ bestimmen lässt. Die Schaltung 1 umfasst einen aktiven Leistungsfaktorkorrekturfilter PFC, welcher zwei Eingänge E1, E2 aufweist, die mit einer Netzspannungsversorgung verbunden sind. In dem vorliegenden Ausführungsbeispiel ist die Netzspannungsversorgung eine 230 V AC-Netzspannung.

Ferner weist die Schaltung 1 einen Inverter 20 auf. Der Inverter 20 ist mit einem elektronisch kommutierbaren Motor (EC-Motor) 3 schaltungstechnisch verbunden. Zwischen dem Leistungsfaktorkorrekturfilter PFC und dem Inverter 20 befindet sich der zu überwachende Zwischenkreiskondensator $C_{ZK}$. Ferner weist die Schaltung 1 eine Auswerteschaltung 30 umfassend einen Mikrocontroller auf.

Die Auswerteschaltung 30 erhält vom Leistungsfaktorkorrekturfilter PFC die dargestellten physikalischen Messgrößen Netzstrom IC-Netz, Netzspannung V-Netz und Zwischenkreisspannung $V_{ZK}$. Ferner erhält die Auswerteschaltung 30 vom Inverter den Inverterstrom $I_{INV}$ und die Zwischenkreisspannung $V_{ZK}$. Die Beschreibung des Ausführungsbeispiels bezieht sich insbesondere auf ein System mit einem aktiven PFC und einem EC-Motor mit geringen dynamischen Anforderungen, was bedeutet, dass geringe Drehmoment- und geringe Drehzahländerungen gegeben sind.

Durch die konkrete Kenntnis der Eingangsspannung V-Netz und des Eingangsstroms I-Netz, die durch die PFC-Regelung bereits gemessen werden, kann die von dem Leistungsfaktorkorrekturfilter PFC über eine Netzhalbwelle aufgenommene elektrische Leistung ermittelt werden. Des Weiteren ist die Leistung des Inverters, der den EC-Motor antreibt, bekannt. Die Ermittlung des Leistung des Inverters 20 erfolgt über dessen Sensorik oder aus den Parametern der Motorregelung. Diejenige von dem Leistungsfaktorkorrekturfilter PFC aus dem Netz aufgenommene elektrische Leistung und die vom Inverter 20 aufgenommene elektrische Leistung kann im stationären Betrieb über eine Netzperiode betrachtet als konstant angenommen werden. Demzufolge herrscht ein Quasigleichgewicht an Leistungsaufnahme des Leistungsfaktorkorrekturfilters PFC aus dem Netz und der Leistungsaufnahme des Inverters 20. Die vom Spannungsnetz aufgenommene elektrische Leistung ist jedoch innerhalb einer Netzhalbwelle betrachtet auf die Netzfrequenz abhängig vom Strom und der Spannung und weist einen sinusquadratförmigen Anteil auf. Der Inverter 20 bzw. der daran angeschlossene EC-Motor 3 soll idealerweise eine konstante Leistungsaufnahme besitzen.

Die tatsächlichen Unterschiede in der Leistungsaufnahme führen innerhalb einer Netzperiode zu einem Energieüberschuss bzw. Energiebedarf. Die Differenz aus der aufgenommenen und der abgegebenen elektrischen Energie innerhalb einer halben Netzperiode wird im Zwischenkreiskondensator $C_{ZK}$ gespeichert und sorgt dort für ein Ansteigen bzw. Abfallen der Zwischenkreisspannung $V_{ZK}$ innerhalb der genannten Netzperiode.

Wird nun der Spannungsoffset als auch die Spannung selbst ausgewertet, so lässt sich damit gemäß folgender Formel die im Zwischenkreiskondensator $C_{ZK}$ gespeicherte elektrische Energie berechnen:

$$W_1 = \tfrac{1}{2}\, C_{ZK} \cdot U_{ZK1}{}^2$$

$$W_2 = \tfrac{1}{2}\, C_{ZK} \cdot U_{ZK2}{}^2$$

Dabei ist $U_{ZK1}$ bzw. $U_{ZK2}$ jeweils die Zwischenkreisspannung, die einerseits vom Leistungsfaktorkorrekturfilter PVC bzw. vom Inverter 20 erhalten wird.

Da die gespeicherten elektrischen Energien zu jedem Zeitpunkt während des Betriebs bekannt sind, kann durch das einfache Umstellen der Gleichungen der Wert der Kapazität des Zwischenkreiskondensators $C_{ZK}$ ermittelt werden.

Im Folgenden werden zwei Varianten dieser zunächst beschriebenen Grundidee erläutert.

In einer ersten Möglichkeit wird das Verfahren durchgeführt, ohne dass eine Eingangsspannungsmessung durch den Leistungsfaktorkorrekturfilter PFC erfolgt. Wird die Netzspannung folglich nicht gemessen, so kann jedoch bei sinusförmigen Netzspannungsformen eine Abschätzung darüber getroffen werden. Hierzu ist zunächst der Strom durch eine Boostdiode zu ermitteln. Dies kann entweder direkt mithilfe einer Strommessschaltung oder alternativ indirekt aus dem gemessenen Netzstrom I-Netz erfolgen. Der Netzstrom I-Netz wird, wie zuvor beschrieben, bereits vom Leistungsfaktorkorrekturfilter PFC an die Auswerteschaltung 30 übergeben. Da der Diodenstrom $I_D$ in den Knotenpunkt zum Zwischenkreiskondensator $C_{ZK}$ und zum Inverter 20 fließt, bedeutet dies, dass sich der Diodenstrom $I_D$ in den Zwischenkreiskondensatorstrom $I_{ZK}$ und den Inverterstrom $I_{INV}$ aufteilt.

Bei einer Messung des Netzstroms wird mithilfe der Duty Cycles eine Stromberechnung angestellt, welcher konkrete Anteile des Stroms durch die Boost-Diode fließt und welcher Anteil durch den ebenso vorhandenen Transistor des Leistungsfaktorkorrekturfilters PFC.

Somit kann nach Erhalt der Kenntnis des Inverterstroms $I_{INV}$ der auf den Zwischenkreiskondensator $C_{ZK}$ fließende Zwischenkreiskondensatorstrom $I_{ZK}$ durch einfache Subtraktion errechnet werden. Durch Integration des Stroms bzw. Bestimmung der Ladungsträger lässt sich dann der Kapazitätswert C des Zwischenkreiskondensators $C_{ZK}$ bestimmen.

Eine weitere alternative Methode wird im Folgenden mit Bezug auf die Fig. 2 beschrieben. Diese Figur stellt eine Ausführungsform mittels bandpassgefiltertem Beobachter dar. Diese Möglichkeit zur Ermittlung der Zwischenkreiskapazität des Zwischenkreiskondensators $C_{ZK}$ stellt eine Nachbildung mittels eines im Folgenden näher beschriebenen Beobachtersystems dar.

Der in Fig. 2 dargestellte Beobachter umfasst die Eingänge $U_{ZK}$, $M_{EAS}$ sowie $I_D$ für den Diodenstrom und $I_{INV}$ für den Inverterstrom. Aus der Strom-Differenz wird der Strom $\Delta I$ ermittelt, welcher einem Integrator des Beobachtersystems zugeführt wird. Der Ausgang dieses Integrators stellt die Spannungsgröße $U_{ZK,\,EST}$ bereit, welche an einen Transformator TP des Beobachtersystems übergeben wird. Ein zweiter Transformator TP erhält am Eingang die Größe $U_{ZK,\,MEAS}$ und übergibt am Ausgang die Größe $U_{ZK,\,MEAS}$, TP nach der Transformation an den zweiten Integrator. Die Werte werden über den zweiten Integrator wieder der Regelschleife zugeführt und hinter dem zweiten Integrator erfolgt die Ausgabe des Wertes 1 durch $C_{ZK,\,IST}$.

Da $\Delta I$ als Strom durch den Zwischenkreiskondensator $C_{ZK}$ betrachtet wird, wird dieser mit dem Wert $C_{EST}$ multipliziert und anschließend integriert, was der Berechnungsvorschrift eines Kondensators entspricht. Die hierdurch am Integrierer entstehende Ausgangsspannung $U_{ZK,\,EST}$ wird mittels eines Hochpasses gefiltert. Hierzu wird von $U_{ZKS}$ ein tiefpassgefilterter Anteil $U_{ZKS,\,TP}$ abgezogen. Die dadurch entstehende Spannung wird als $U_{ZK\,EST,\,HP}$ bezeichnet. Die auf diese Art und Weise berechnete Spannung $U_{ZK,\,EST}$ weist lediglich den 100 Hz Ripple aufgrund der pulsierenden Leistungsaufnahme aus dem Netz auf (bei einer Netzfrequenz von 50 Hz).

Dieser Spannungsripple wird von einer hochpassgefilterten Netzspannung $U_{ZK,\,Netz,\,HP}$ subtrahiert und deren Differenz $\Delta U$ wird verstärkt aufintegriert.

Die durch eine Abweichung des Modells vom realen Zwischenkreiskondensator $C_{ZK}$ entstehende $\Delta U$ ist somit ein Maß dafür, wie gut und exakt das Modell die Wirklichkeit abbildet. Wird $\Delta U$ aufintegriert und als $C_{EST}$ angegeben, so entsteht hierdurch eine Beobachterregelschleife, die das Modell kontinuierlich dem tatsächlich gemessenen Kondensator nachführt.

Der Vorteil liegt darin, dass diese Lösung leicht zu implementieren ist und keine schwierigen Rechenoperationen erforderlich sind. Ferner ist eine Mittelung über eine Vielzahl von Perioden möglich, womit einmalig auftretende Störungen und Messschwankungen gut ausgeglichen werden können.

In der Figur 3 ist ein Diagramm gezeigt, bei dem neben der Brummspannung $\Delta U\_d$ (Kennlinie a), der Laststrom I_L (Kennlinie d) und der Frequenz der Netzspannung f_ac (Diagramm Zeitdifferenz 2 * (t2-t0)) dargestellt sind.

Über den proportionalen Zusammenhang aus Kapazität, Strom und Spannungshub (Brummspannung) samt Zeiten der fallenden und steigenden Spannung (Zeitdifferenzen zwischen t0, t1 und t2) kann Rückwärts der mittlere Ladestrom des Zwischenkreiskondensators errechnet werden, nach der folgenden Formel:

$$I_{Ladestrom, Mittel\_t0/t1} = \frac{C_{Elko} * \Delta U_d}{\Delta t} \ mit \ \Delta t = t1 - t0 \ und \ \Delta U_d = deltaU$$

Der mittlere RMS-Ladestrom aus dem Netz über die gesamte Netzperiode ergibt sich dann aus $I_{Ladestrom} * \Delta t_{Nachladezeit} / t_{Netzperiode}$.

Falls die Betriebsschaltung am Netzeingang einen NTC zur Einschaltstrombegrenzung oder andere Widerstände (bestimmungsgemäß oder auch parasitär) aufweist, kann durch den unbekannten Spannungsabfall über diese Widerstände keine genaue Rückrechnung auf die Netzspannung via folgende Gleichung erfolgen:

$$U_{Netzspannung} = \frac{U_{Zwischenkreis}}{\sqrt{2}}$$

Um eine genaue Bestimmung der Netzspannung aus dem bekannten Zwischenkreisspannungswert zu erhalten, müssten 2 Diodenstrecken in der Brückengleichrichtung (~2*0,8V = 1,6V) sowie besagter Spannungsabfall über den Widerständen im Eingangskreis berücksichtigt werden.

Eine Bestimmung des Spannungsabfalls über den Widerständen im Eingangskreis kann nun mit Hilfe des oben errechneten Nachladestroms sowie einer im Mikrocontroller hinterlegten Tabelle aus Umgebungstemperatur und Strom über die Netzeingangskomponenten erfolgen. Letztere Tabelle oder Datensätze sind notwendig, um die Temperaturabhängigkeit der Widerstände im Eingangskreis (z.B. bei NTC) durch Eigenerwärmung oder Umgebungstemperatur zu kompensieren.

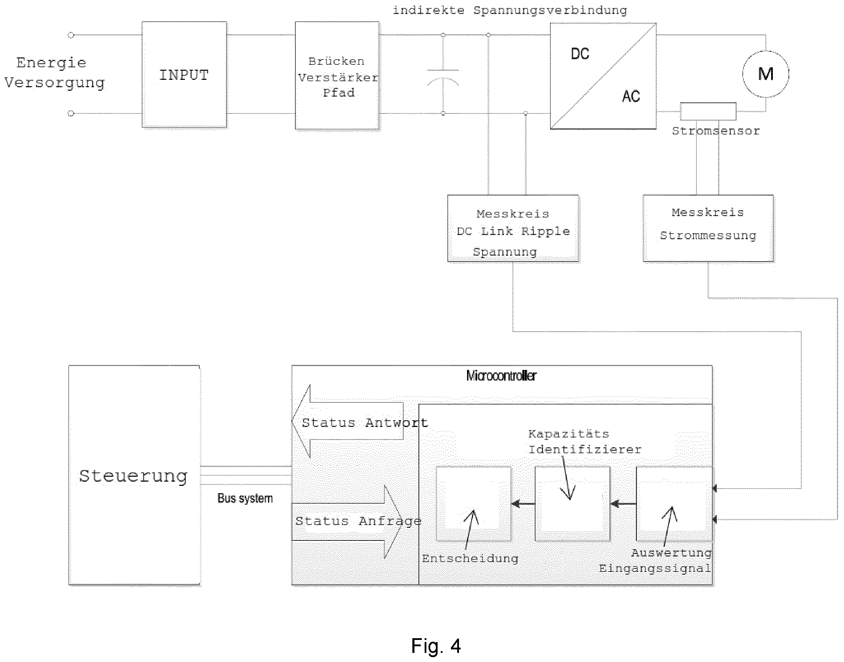

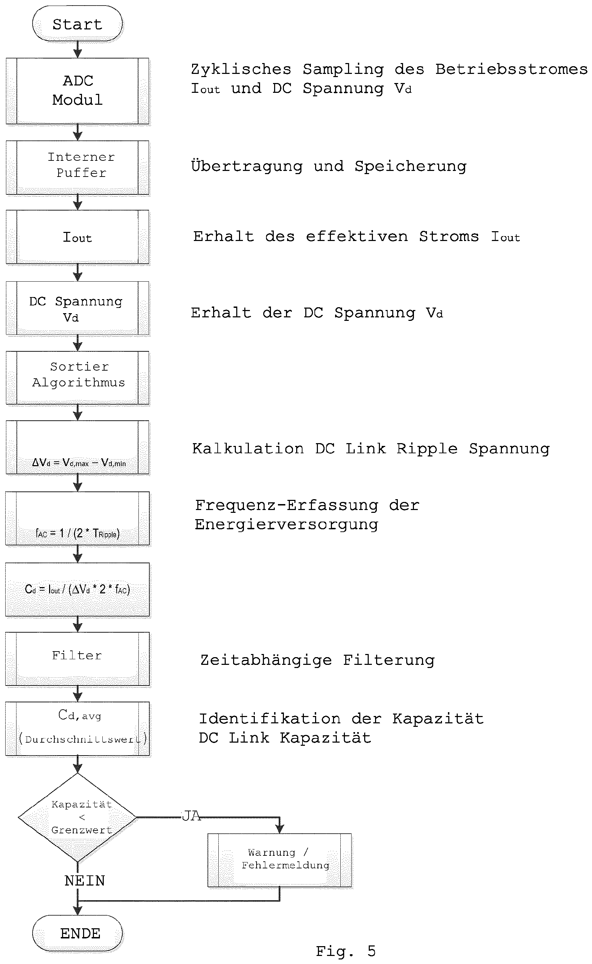

Die Frühausfallerkennung durch Restkapazitätsmessung des Zwischenkreiskondensators ist eine Methode, bei der die Vergangenheit (Laufzeit, Temperatur, Ripplestrombelastung) und deren Einwirkung auf den Kondensator betrachtet werden. Mit dem optional errechneten Nachladestrom sowie dem ebenfalls durch Strommessung bekannten Motorstrom kann ein kombinierter Ripplestrom des Kondensators errechnet werden. Zusammen mit der Umgebungstemperatur durch einen weiteren optionalen Temperatursensor kann damit auch eine vorwärtsgerichtete Berechnung der verbleibenden Lebensdauer bei als konstant angenommenem vorliegenden Arbeitspunkt (Temperatur und Leistung) erfolgen. Ein entsprechendes Ausführungsbeispiel eines Prinzipschaltbildes findet sich in der Figur 4 und ein Ablaufdiagramm zur Kapazitätsbestimmung findet sich in der Figur 5.

Die Erfindung beschränkt sich in ihrer Ausführung nicht auf die vorstehend angegebenen bevorzugten Ausführungsbeispiele.

**Patentansprüche**

1. Verfahren zur Überwachung eines Zwischenkreiskondensators ($C_{ZK}$) in einem elektrischen Zwischenkreis einer an einer Netzspannung $V_{ac}$ betriebenen Schaltung (1), umfassend einen Leistungsfaktorkorrekturfilter (PFC) und einen Inverter (20), wobei sich zwischen dem Leistungsfaktorkorrekturfilter (PFC) und dem Inverter (20) der zu überwachende Zwischenkreiskondensator ($C_{ZK}$) befindet, wobei während dem Betrieb der Schaltung (1) wenigstens in bestimmten Zeitabständen über die Betriebszeit die Zwischenkreiskapazität C des Zwischenkreiskondensators ($C_{ZK}$) durch Messen eines mit der doppelten Frequenz der Netzspannung pulsierenden Leistungsripples W einer am Zwischenkreiskondensators ($C_{ZK}$) sich einstellenden Zwischenkreisspannung $V_{ZK}$ ermittelt und mittels einer Auswerteschaltung (30) aus der so ermittelten Zwischenkreiskapazität C eine Rest-Lebensdauer oder das Lebensdauer- und/oder Brauchbarkeitsdauer-Ende des Zwischenkreiskondensators ($C_{ZK}$) bestimmt wird, wobei der Leistungsfaktorkorrekturfilter (PFC) ein aktiver Leistungsfaktorkorrekturfilter ist und die Erfassung der über eine Netzhalbwelle aufgenommene Leistung des Leistungsfaktorkorrekturfilters mittels der zur Regelung des Leistungsfaktorkorrekturfilters (PFC) bereits zuvor ermittelten Netzeingangsspannung und dem bereits dazu ermittelten Eingangsstrom $i_{Netz}$ erfolgt.

2. Verfahren nach Anspruch 1, **dadurch gekennzeichnet, dass** zur Ermittlung der Zwischenkreiskapazität C des Zwischenkreiskondensators ($C_{ZK}$) eine Leistungsmessung und eine Spannungsmessung am Zwischenkreiskondensators ($C_{ZK}$) zur Bestimmung des Spannungsrippels erfolgt.

3. Verfahren nach Anspruch 1 oder 2, **dadurch gekennzeichnet, dass** das Verfahren zur Überwachung des Zwischenkreiskondensators eines über eine den Zwischenkreiskondensator aufweisende Motorsteuerungsschaltung betriebenen EC-Motor (3) verwendet wird, wobei die Motorsteuerungsschaltung eine Sensorik zum Betrieb des EC-Motors (3) aufweist und diese Sensorik gleichzeitig zur Leistungserfassung und/oder Spannungsmessung des Spannungsrippels am Zwischenkreiskondensators ($C_{ZK}$) verwendet wird.

4. Verfahren nach einem der Ansprüche 1 bis 3, **dadurch gekennzeichnet, dass** die Leistungs-erfassung ohne Kenntnis der Netzeingangsspannung $V_{ac}$ erfolgt, indem zunächst der Strom $i_D$ durch eine Boost-Diode des Leistungsfaktorkorrekturfilters (PFC) ermittelt wird und wobei aus folgendem Zusammenhang und der Erfassung des Inverterstroms $I_{inv}$ der verbleibende Anteil ermittelt wird, der als Zwischenkreiskondensatorstrom $I_{ZK}$ zum Zwischenkreiskondensator ($C_{ZK}$) fließt: $I_{ZK} = io - I_{inv}$ und daraus sich unmittelbar durch Integration des Stromes $I_{ZK}$ oder durch Bestimmung der Ladungsträger der aktuelle Kapazitätswert des Zwischenkreiskondensators ($C_{ZK}$) bestimmen lässt.

5. Verfahren nach Anspruch 4, wobei die Stromerfassung des Stromes $i_D$ mittels indirekter Messung aus dem gemessenen Netzstrom erfolgt, indem mit Hilfe eines Duty-Cycles berechnet wird, welcher Anteil des Stroms durch die Boost-Diode fließt.

6. Verfahren nach einem der Ansprüche 1 bis 5, **dadurch gekennzeichnet, dass** die Ermittlung der Zwischenkreiskapazität durch ein Beobachtersystem erfolgt, wobei der Strom $i_D$ durch eine Diode und der Inverterstrom $I_{inv}$ durch Messen der beiden Ströme erfolgt und die Differenz als Zwischenkreiskondensatorstrom $I_{ZK}$ betrachtet wird und dieser mit einem Kapazitätswert $C_{est}$ multipliziert und anschließend integriert wird und die hierdurch am Integrierer des Beobachtersystems entstehende Ausgangsspannung $U_{ZK\_est}$ wird mittels eines Hochpasses gefiltert, um dadurch den hochpassgefilterten Spannungsrippel $U_{ZK\_est,HP}$ zu erhalten, um diesen von einer hochpassgefilterten Netzspannung $U_{ZK,Netz,HP}$ zu subtrahieren und die ermittelte Differenz $\Delta U$ wird aufintegriert und als $C_{est}$ angegeben, wodurch eine Beobachter/Regelschleife erhalten wird, die das Modell schleifenweise dem tatsächlich gemessenen Kondensator nachführt.

7. Elektrische Schaltung (1) zur Überwachung eines Zwischenkreiskondensators (C) in einem elektrischen Zwischenkreis der an einer Netzspannung $V_{ac}$ betriebenen Schaltung, umfassend einen Leistungsfaktorkorrekturfilter (PFC) und einen Inverter (20), wobei sich zwischen dem Leistungsfaktorkorrekturfilter (PFC) und dem Inverter (20) der zu überwachende Zwischenkreiskondensator ($C_{ZK}$) befindet und eine Auswerteschaltung (30) vorgesehen ist, die ausgebildet ist physikalische Messwerte von dem Leistungsfaktorkorrekturfilter (PFC) und dem Inverter (20) zu erhalten oder zu erfassen und während dem Betrieb der Schaltung (1) wenigstens in bestimmten Zeitabständen über die Betriebszeit die Zwischenkreiskapazität C des Zwischenkreiskondensators ($C_{ZK}$) durch Messen eines mit der doppelten Frequenz der Netzspannung pulsierenden Leistungsrippels W einer am Zwischenkreiskondensators ($C_{ZK}$) sich einstellenden Zwischenkreisspannung zu ermitteln und aus der so ermittelten Zwischenkreiskapazität C eine Rest-Lebensdauer oder das Lebensdauer- und/oder Brauchbarkeitsdauer-Ende des Zwischenkreiskondensators ($C_{ZK}$) zu bestimmen, wobei der Leistungsfaktorkorrekturfilter (PFC) ein aktiver Leistungsfaktorkorrekturfilter ist und die Erfassung der über eine Netzhalbwelle aufgenommene Leistung des Leistungsfaktorkorrekturfilters mittels der zur Regelung des Leistungsfaktorkorrekturfilters (PFC) bereits zuvor ermittelten Netzeingangsspannung und dem bereits dazu ermittelten Eingangsstrom iNetz erfolgt.

**Claims**

1. A method for monitoring a DC link capacitor ($C_{ZK}$) in an electrical DC link of a circuit (1) operated on a mains voltage $V_{ac}$, the circuit comprising a power factor correction filter (PFC) and an inverter (20), the DC link capacitor ($C_{ZK}$) to be monitored being between the power factor correction filter (PFC) and the inverter (20), wherein, during the operation of the circuit (1), the DC link capacitance C of the DC link capacitor ($C_{ZK}$) is determined at least at certain time intervals over the operating time by measuring a power ripple W of a DC link voltage ($V_{ZK}$), which DC link voltage arises at the DC link capacitor ($C_{ZK}$), said power ripple pulsing at twice the frequency of the mains voltage, and the remaining service life or the service life end and/or usability end of the DC link capacitor ($C_{ZK}$) is determined, by means of an evaluation circuit (30), from the DC link capacitance C determined in this way, wherein the power factor correction filter (PFC) is an active power factor correction filter, and the power of the power factor correction filter consumed over a mains half-wave is detected by means of the mains input voltage that was determined previously in order to regulate the power factor correction filter (PFC) and the input current $i_{Netz}$ already determined for this purpose.

2. The method as set forth in claim 1, **characterized in that**, in order to determine the DC link capacitance C of the DC link capacitor ($C_{ZK}$), a power measurement and a voltage measurement are performed at the DC link capacitor ($C_{ZK}$) in order to determine the voltage ripple.

3. The method as set forth in claim 1 or 2, **characterized in that** the method is used to monitor the DC link capacitor of an EC motor (3) that is operated via a motor control circuit having the DC link capacitor, the motor control circuit having a sensor system for operating the EC motor (3), and this sensor system is used simultaneously to detect the power and/or measure the voltage of the voltage ripple at the DC link capacitor ($C_{ZK}$).

4. The method as set forth in one of the preceding claims 1 to 3, **characterized in that** the power is measured without knowledge of the mains input voltage $V_{ac}$ by first determining the current $i_D$ through a boost diode of the power factor correction filter (PFC) and then determining the remainder from the following relationship and the detection of the inverter current $I_{inv}$ that is flowing as the DC link capacitor current $I_{ZK}$ to the DC link capacitor ($C_{ZK}$): $I_{ZK} = i_D - I_{inv}$, and the current capacitance value of the DC link capacitor ($C_{ZK}$) can be determined directly from this by integrating the current $I_{ZK}$ or by determining the charge carriers.

5. The method as set forth in claim 4, wherein the current $i_D$ is detected by means of indirect measurement from the measured mains current by using a duty cycle to calculate the proportion of the current flowing through the boost diode.

6. The method as set forth in one of the preceding claims 1 to 5, **characterized in that** the DC link capacitance is determined by means of an observer system, the current $i_D$ through a diode and the inverter current $I_{inv}$ is performed by measuring the two currents, the difference being regarded as the DC link capacitor current $I_{ZK}$, and this is multiplied by a capacitance value $C_{est}$ and then integrated, and the output voltage $U_{ZK\_est}$ resulting from this at the integrator of the observer system is filtered by means of a high-pass filter in order to obtain the high-pass-filtered voltage ripple $U_{ZK\_est, HP}$ in order to subtract it from a high-pass-filtered mains voltage $U_{ZK, mains, HP}$, and the determined difference $\Delta U$ is integrated and given as $C_{est}$, whereby an observer/control loop is obtained which tracks the model loopwise to the actually measured capacitor.

7. An electrical circuit (1) for monitoring a DC link capacitor (C) in an electrical DC link of a circuit (1) operated on a mains voltage $V_{ac}$, the circuit comprising a power factor correction filter (PFC) and an inverter (20), the DC link capacitor ($C_{ZK}$) to be monitored being between the power factor correction filter (PFC) and the inverter (20) and an evaluation circuit (30) is provided which is designed to acquire or detect physical measured values from the power factor correction filter (PFC) and the inverter (20) and, during the operation of the circuit (1), the DC link capacitance C of the DC link capacitor ($C_{ZK}$) is determined at least at certain time intervals over the operating time by measuring a power ripple W of a DC link voltage $V_{ZK}$, which DC link voltage arises at the DC link capacitor ($C_{ZK}$), said power ripple pulsing at twice the frequency of the mains voltage, and the remaining service life or the service life end and/or usability end of the DC link capacitor ($C_{ZK}$) is determined from the DC link capacitance C determined in this way, wherein the power factor correction filter (PFC) is an active power factor correction filter, and the power of the power factor correction filter consumed over a mains half-wave is detected by means of the mains input voltage that was determined previously in order to regulate the power factor correction filter (PFC) and the input current $i_{Netz}$ already determined for this purpose.

**Revendications**

1. Procédé permettant de surveiller un condensateur de circuit intermédiaire ($C_{ZK}$) dans un circuit intermédiaire électrique d'un circuit (1) fonctionnant sur une tension de réseau $V_{ac}$, comprenant un filtre de correction de facteur de puissance (PFC) et un onduleur (20), le condensateur de circuit intermédiaire ($C_{ZK}$) à surveiller se trouvant entre le filtre de correction de facteur de puissance (PFC) et l'onduleur (20), dans lequel, pendant le fonctionnement du circuit (1), au moins à des intervalles déterminés pendant le temps de fonctionnement, la capacité de circuit intermédiaire C du condensateur de circuit intermédiaire ($C_{ZK}$) est établie en mesurant une ondulation de puissance W, pulsée à deux fois la fréquence de la tension de réseau, d'une tension de circuit intermédiaire $V_{ZK}$ survenant au niveau du condensateur de circuit intermédiaire ($C_{ZK}$), et une durée de vie résiduelle ou la fin de la durée de vie et/ou la fin de la durée de vie utile du condensateur de circuit intermédiaire ($C_{ZK}$) sont déterminées au moyen d'un circuit d'évaluation (30) à partir de la capacité de circuit intermédiaire C établie, dans lequel le filtre de correction de facteur de puissance (PFC) est un filtre de correction de facteur de puissance actif, et la détection de la puissance absorbée durant une demi-onde de réseau du filtre de correction de facteur de puissance est effectuée au moyen de la tension d'entrée de réseau, déjà établie précédemment pour réguler le filtre de correction de facteur de puissance (PFC), et du courant d'entrée $i_{Netz}$ déjà établi à cet effet.

2. Procédé selon la revendication 1, **caractérisé en ce qu'**une mesure de puissance et une mesure de tension sont effectuées au niveau du condensateur de circuit intermédiaire ($C_{ZK}$) pour déterminer l'ondulation de tension afin d'établir la capacité de circuit intermédiaire C du condensateur de circuit intermédiaire ($C_{ZK}$).

3. Procédé selon la revendication 1 ou 2, **caractérisé en ce que** le procédé est utilisé pour surveiller le condensateur de circuit intermédiaire d'un moteur à commutation électronique (EC) (3) actionné par un circuit de commande de moteur présentant le condensateur de circuit intermédiaire, dans lequel le circuit de commande de moteur présente un système de capteurs pour faire fonctionner le moteur EC (3), et ce système de capteurs est utilisé en même temps pour détecter la puissance et/ou mesurer la tension de l'ondulation de tension au niveau du condensateur de circuit intermédiaire ($C_{ZK}$).

4. Procédé selon l'une quelconque des revendications 1 à 3, **caractérisé en ce que** la détection de puissance est effectuée sans connaître la tension d'entrée de réseau $V_{ac}$ **en ce que** d'abord le courant $i_D$ à travers une diode de boost du filtre de correction de facteur de puissance (PFC) est établi, et dans lequel la part restante est établie à partir de la relation suivante et de la détection du courant d'onduleur $I_{inv}$ qui circule en tant que courant de condensateur de circuit intermédiaire $I_{ZK}$ jusqu'au condensateur de circuit intermédiaire ($C_{ZK}$) : $I_{ZK} = i_D - I_{inv}$, de ce fait, ce qui permet de déterminer directement la valeur de capacité actuelle du condensateur de circuit intermédiaire ($C_{ZK}$) par l'intégration du courant $I_{ZK}$ ou par la détermination des porteurs de charge.

5. Procédé selon la revendication 4, dans lequel la détection de courant du courant $i_D$ a lieu au moyen d'une mesure indirecte à partir du courant de réseau mesuré en calculant à l'aide d'un cycle de fonctionnement quelle part du courant passe par la diode de boost.

6. Procédé selon l'une quelconque des revendications 1 à 5, **caractérisé en ce que** l'établissement de la capacité de circuit intermédiaire est effectué par un système d'observation, dans lequel le courant $i_D$ par une diode et le courant d'onduleur $I_{inv}$ sont effectués en mesurant les deux courants, et la différence est considérée comme un courant de condensateur de circuit intermédiaire $I_{ZK}$, et celui-ci est multiplié par une valeur de capacité $C_{est}$ et est ensuite intégré, et la tension de sortie $U_{ZK\_est}$ survenant de ce fait au niveau de l'intégrateur du système d'observation est filtrée au moyen d'un filtre passe-haut pour obtenir ainsi l'ondulation de tension filtrée passe-haut $U_{ZK\_est,HP}$ afin de la soustraire d'une tension de réseau filtrée passe-haut $U_{ZK,Netz,HP}$, et la différence $\Delta U$ établie est intégrée en plus et indiquée par $C_{est}$, de sorte qu'une boucle d'observation/ d'asservissement est obtenue qui asservit le modèle boucle par boucle au condensateur réellement mesuré.

7. Circuit électrique (1) permettant de surveiller un condensateur de circuit intermédiaire (C) dans un circuit intermédiaire électrique du circuit fonctionnant sous une tension de réseau $V_{ac}$, comprenant un filtre de correction de facteur de puissance (PFC) et un onduleur (20), le condensateur de circuit intermédiaire ($C_{ZK}$) à surveiller se trouvant entre le filtre de correction de facteur de puissance (PFC) et l'onduleur (20), et un circuit d'évaluation (30) est prévu qui est réalisé pour obtenir ou détecter des valeurs de mesure physiques du filtre de correction de facteur de puissance (PFC) et de l'onduleur (20) et pour établir pendant le fonctionnement du circuit (1), au moins à des intervalles déterminés pendant le temps de fonctionnement, la capacité de circuit intermédiaire C du condensateur de circuit intermédiaire ($C_{ZK}$) en mesurant une ondulation de puissance W, pulsée à deux fois la fréquence de la tension de réseau, d'une tension de circuit intermédiaire survenant au niveau du condensateur de circuit intermédiaire ($C_{ZK}$), et pour déterminer une durée de vie résiduelle ou la fin de la durée de vie et/ou la fin de la durée de vie utile du condensateur de circuit intermédiaire ($C_{ZK}$) à partir de la capacité de circuit intermédiaire C ainsi établie, dans lequel le filtre de correction de facteur de puissance (PFC) est un filtre de correction de facteur de puissance actif, et la détection de la puissance absorbée durant une demi-onde de réseau du filtre de correction de facteur de puissance est effectuée au moyen de la tension d'entrée de réseau, déjà établie précédemment pour réguler le filtre de correction de facteur de puissance (PFC), et du courant d'entrée $i_{Netz}$ déjà établi à cet effet.

Fig. 1

Fig. 2

Fig. 3

Fig. 4

Start

ADC
Modul

Zyklisches Sampling des Betriebsstromes
$I_{out}$ und DC Spannung $V_d$

Interner
Puffer

Übertragung und Speicherung

$I_{out}$

Erhalt des effektiven Stroms $I_{out}$

DC Spannung
$V_d$

Erhalt der DC Spannung $V_d$

Sortier
Algorithmus

$\Delta V_d = V_{d,max} - V_{d,min}$

Kalkulation DC Link Ripple Spannung

$f_{AC} = 1 / (2 * T_{Ripple})$

Frequenz-Erfassung der
Energierversorgung

$C_d = I_{out} / (\Delta V_d * 2 * f_{AC})$

Filter

Zeitabhängige Filterung

$C_{d,avg}$
(Durchschnittswert)

Identifikation der Kapazität
DC Link Kapazität

Kapazität
<
Grenzwert — JA

Warnung /
Fehlermeldung

NEIN

ENDE

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102016004774 A1
- DE 102004036211 A1
- EP 2637030 A1
- DE 102004035723 A1
- DE 102004052977 A1
- US 2009072982 A

**In der Beschreibung aufgeführte Nicht-Patentliteratur**

- An Online and Noninvasive Technique for the Condition Monitoring of Capacitors in Boost Converters. **GUSTAVO MALAGONI BUIATTI et al.** IEEE TRANSACTIONS ON INSTRUMENTATION AND MEASUREMENT. IEEE SERVICE CENTER, 01. August 2010, vol. 59, 2134-2143